(19) Europäisches Patentamt
European Patent Office
Office européen des brevets

(11) **EP 2 177 923 B1**

(12) **EUROPEAN PATENT SPECIFICATION**

(45) Date of publication and mention
of the grant of the patent:
**09.02.2011 Bulletin 2011/06**

(51) Int Cl.:
***G01R 31/01*** *(2006.01)*       ***H02M 7/48*** *(2007.01)*
***H05B 41/298*** *(2006.01)*

(21) Application number: **09012816.6**

(22) Date of filing: **09.10.2009**

(54) **Discharge lamp lighting device and illumination fixture with end of life detection**

Beleuchtungsvorrichtung für eine Entladelampe und Beleuchtungsbefestigung mit Detektion des Endes des Lebensdauers

Dispositif d'éclairage par lampe à décharge et accessoire d'illumination avec détection de fin de vie

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **17.10.2008 JP 2008268233**

(43) Date of publication of application:
**21.04.2010 Bulletin 2010/16**

(73) Proprietor: **Panasonic Electric Works Co., Ltd. Kadoma-shi Osaka 571-8686 (JP)**

(72) Inventors:
• **Hideo, Ootani Kasiba, Nara (JP)**

• **Kazuyoshi, Tsukuda Ikoma, Nara (JP)**
• **Keisuke, Ueda Osaka (JP)**

(74) Representative: **Rüger, Barthelt & Abel Patentanwälte Postfach 10 04 61 73704 Esslingen a.N. (DE)**

(56) References cited:
**EP-A1- 1 814 214       JP-A- 3 269 269
US-A1- 2002 085 397       US-B1- 6 252 357**

**Description**

The present invention relates to a discharge lamp lighting device for lighting a discharge lamp and relates to an illumination fixture using the device.

When an accumulated lighting time becomes long and a life time has expired, a discharge lamp and a discharge lamp lighting device for lighting the discharge lamp cannot give an appropriate performance. For example, some cases occur in the discharge lamp; a filament is disconnected and a luminous flux is reduced. In addition, the discharge lamp lighting device includes a rectifier, a high-frequency switching element, a smoothing electrolytic capacitor, and the like, and when the electrolytic capacitor is deteriorated among them, the discharge lamp cannot be appropriately lighted.

Moreover, regarding the illumination fixture that mounts the discharge lamp and the discharge lamp lighting device, when the accumulated lighting time becomes long, a metallic portion rusts and a plastic portion is damaged because of the deterioration.

The life time of the discharge lamp, the discharge lamp lighting device, and the illumination fixture is judged based on: the fact that the discharge lamp is not appropriately lighted actually; or experience of a user. Among them, in the case where the discharge lamp is not appropriately lighted, the user faces inconvenience until a substitute is prepared. In addition, in the case where the user empirically judged the life time of the illumination fixture including the discharge lamp lighting device expired, the user may change the illumination fixture before the actual life time, resulting in a wasteful expenditure.

However, the discharge lamp lighting device and the illumination fixture have some portions whose life time cannot be judged on the basis of the inappropriate lighting of the discharge lamp or the user's experience. As a result, the discharge lamp lighting device and the illumination fixture are continuously used even though the life time of these portions have expired, and thereby a risk of serious accident such as a burnout or firing of components and a damage or fall of the fixture is caused.

Accordingly, some techniques for judging the expired life time of the discharge lamp lighting device and the illumination fixture and informing the user of the expiration have been proposed.

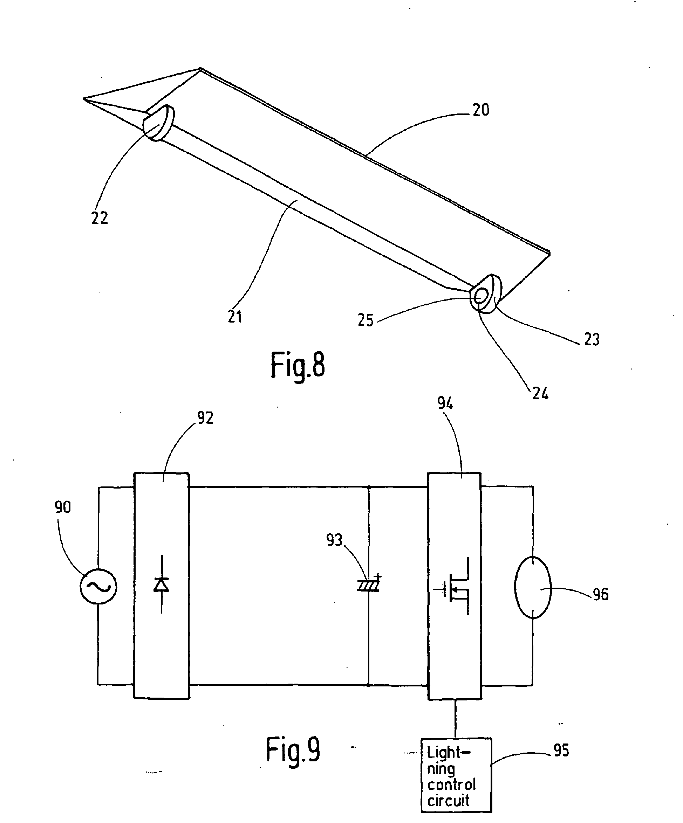

Fig. 9 is a view showing a schematic configuration of a conventional discharge lamp lighting device. In Fig. 9, an output of a commercial power source 90 is rectified by a rectifier 92, and after being smoothed by a smoothing capacitor 93, the rectified direct-current output is converted into an alternating-current output by an inverter circuit 94 and is supplied to a discharge lamp 96. At this time, a lighting control circuit 95 controls an operation of the inverter circuit 94, and thereby the electric power supplied to the discharge lamp 96 is controlled to be a predetermined value.

Since the smoothing capacitor 93 requires a large electrostatic capacitance, an aluminum-foil electrolytic capacitor is generally used. The aluminum-foil electrolytic capacitor reduces an electrostatic capacitance with increase of the time of use because an electrochemical reaction is caused in the capacitor, and accordingly has characteristics of damaging an original smoothing function and increasing the loss. For this reason, a life time is provided to the aluminum-foil electrolytic capacitor (for example, a guaranteed value is 12000 hours at 105°C).

Since the life time of the aluminum-foil electrolytic capacitor is shorter than those of other electronic components, the life time of the discharge lamp lighting device is determined depending on that of the aluminum-foil electrolytic capacitor as a result.

Then, a life time detection device for detecting a ripple voltage or a ripple current of a smoothing capacitor and comparing the detected voltage or current to a threshold value and for detecting a life time of the smoothing capacitor on the basis of the comparison result is proposed (for example, refer to Patent document 1).

However, the above-mentioned conventional life time detection device has to detect a relatively-small ripple component (for example, the ripple voltage of several volts superimposed on an output voltage of several hundred volts) superimposed on an output voltage of the smoothing capacitor, and accordingly there is a problem that the measurement is difficult and an error of the measurement is large. In addition, the judgment of life time is carried out only when an input of the inverter circuit is turned off by an operation for turning off the power source or a power failure has occurred, and the life time of the smoothing capacitor could not be judged while the discharge lamp is lighted.

To solve the problems, a discharge lamp lighting device for voluntarily producing an instant power-failure operation by using a mild discharging characteristic of the discharge lamp and for judging the life time by measuring a voltage between both ends of the smoothing capacitor within a predetermined time is proposed (for example, refer to Patent document 2).

A general type of a recent discharge lamp lighting device can be used at input voltages of 100V, 200V, and 242V. However, the examples described in the above-mentioned Patent documents 1 and 2 have a problem; the ripple current of the smoothing capacitor changes when the input voltage varies, a heat value of the smoothing capacitor accordingly changes, and thus it is difficult to accurately judge the life time.

A table 1 exemplifies a surrounding temperature, a ripple current, heat of ripple current, and an estimated life time calculated from these parameters in a case of employing the aluminum-foil electrolytic capacitor having a guaranteed value of 10000 hours at 105°C as the smoothing capacitor connected to an output terminal of an alternating current-direct current conversion circuit in the discharge lamp lighting device used at input voltages of 100V, 200V, and 242V.
[Table 1]

| Estimated life times of aluminum-foil electrolytic capacitor with a guarantee of 10,000 hours at 105 °C | | | |
|---|---|---|---|
| Vin (V) | 100 | 200 | 242 |
| Surrounding temperature (°C): T2 | 72 | 63 | 62 |
| Ripple current (Arms) | 0.4998 | 0.3911 | 0.3668 |
| Heat of ripple current (°C): T3 | 4.9 | 3.0 | 2.8 |
| Estimated life (time): L2 | 138326 | 226274 | 239176 |

Life time estimation equation

$$L2 = L1 \times 2^a$$

$$a = (T1 + T3 \cdot T2) / 10$$

T1: Surrounding temperature (°C) at which components maker guarantees a life time L1
T2: Allowance value (°C) of surface temperature of actually-used capacitor
T3: Heat (°C) of ripple current guaranteed by components maker
L1: Life time (hour) guaranteed by components maker is equal to 10,000 hours
L2: Designed life time (hour) of an electronic block (commercial product)

Referring to table 1, since a large input current is required in the case of 100V compared to the case where the input voltage is 242V, the ripple current takes a largest value. Based on this, it can be said that the lower the input voltage becomes, the larger the input current becomes, and accordingly the surrounding temperature and the heat of the ripple current tend to be large.

In addition, the estimated life time is approximately 138,000 hours in the case of using the device at 100V, approximately 226,000 hours in the case of using the device at 200V, and approximately 239,000 hours in the case of using the device at 242V.

This means that when the device is used at the input voltage of 200V, the design results in having too much life time compared to the designed life time of 138,000 hours even though the device is assumed to be used at 100V and is designed assuming the designed life time is 138,000 hours. Accordingly, it is difficult to detect and manage the life time of the discharge lamp lighting device used at input voltages of 100V, 200V, and 242V by using the smoothing capacitor.

Patent document 1: Japanese Unexamined Patent Publication No. H07-222436
Patent document 2: Japanese Unexamined Patent Publication No. 2006-129564

Patent document EP 1814214 A1 shows a lighting device according to the preamble of claim 1.

[Disclosure of the Invention]

[Problems to be solved by the Invention]

The present invention has been made considering the above-mentioned circumstances, and intends to provide a discharge lamp lighting device and an illumination fixture able to manage the life time regardless of an input voltage and able to notify the expiration of the life time.

[Means adapted to solve the Problems]

A discharge lamp lighting device of the present invention includes: an alternating current-direct current conversion circuit for converting an alternating current of an arbitrary voltage into a direct current of a predetermined voltage; an inverter circuit for converting the direct current of the predetermined voltage into a high-frequency voltage; a resonant circuit including a capacitor and an inductor for lighting a discharge lamp; and a lighting control circuit for controlling the operations, further includes: an electrolytic capacitor charged by a constant high-frequency current; and a life time detection circuit for detecting a life time of the electrolytic capacitor, wherein: the life time detection circuit determines that the life of the electrolytic capacitor expired when a ripple voltage of the electrolytic capacitor exceeds a predetermined threshold value, and issues an instruction to the lighting control circuit; and the lighting control circuit is configured so as to change an operating frequency of the inverter circuit on the basis of the instruction.

According to the configuration, since a charge current to the electrolytic capacitor is approximately constant, a heat value of the electrolytic capacitor can be constant regardless of the input voltage, and thus the life time of the electrolytic capacitor independent from the input voltage can be designed and accordingly the life time of the discharge lamp lighting device can be designed.

Additionally, according to the present invention, in the above-described discharge lamp lighting device, the electrolytic capacitor is configured so as to be charged by the high-frequency current obtained from the inverter circuit.

According to the configuration, the charge current to the electrolytic capacitor is obtained from the inverter circuit to be approximately constant, a heat value of the electrolytic capacitor can be constant regardless of the input voltage, and thus the life time of the electrolytic capacitor independent from the input voltage can be designed and accordingly the life time of the discharge lamp lighting device can be designed.

Moreover, according to the present invention, in the above-described discharge lamp lighting device, the inductor includes a magnetically-connected secondary winding; and the electrolytic capacitor is configured so as to be charged by the high-frequency current induced by the secondary winding.

According to the configuration, the charge current to the electrolytic capacitor is obtained from the inverter circuit to be approximately constant, a heat value of the electrolytic capacitor can be constant regardless of the input voltage, and thus the life time of the electrolytic capacitor independent from the input voltage can be designed and accordingly the life time of the discharge lamp lighting device can be designed.

In addition, according to the present invention, in the above-described discharge lamp lighting device, the electrolytic capacitor is mounted close to a component, a surface temperature of which is constant in an operation.

According to the configuration, a surface temperature of the electrolytic capacitor can be controlled by using a surface temperature of a component that is not influenced by the input voltage, and thus the life time of the electrolytic capacitor independent from the input voltage can be designed and accordingly the life time of the discharge lamp lighting device can be designed.

Moreover, the present invention is an illumination fixture comprising the above-described discharge lamp lighting device.

According to the configuration, the life time of the discharge lamp lighting device independent from the input voltage can be designed and accordingly the life time of the illumination fixture can be designed.

[Effect of the Invention]

According to the present invention, a discharge lamp lighting device and an illumination fixture able to manage a life time regardless of an inputted voltage and able to notify the expiration of the life time.

[Brief Description of the Drawings]

[Fig. 1] Fig. 1 is a drawing showing a schematic configuration of a discharge lamp lighting device according to a first embodiment of the present invention.

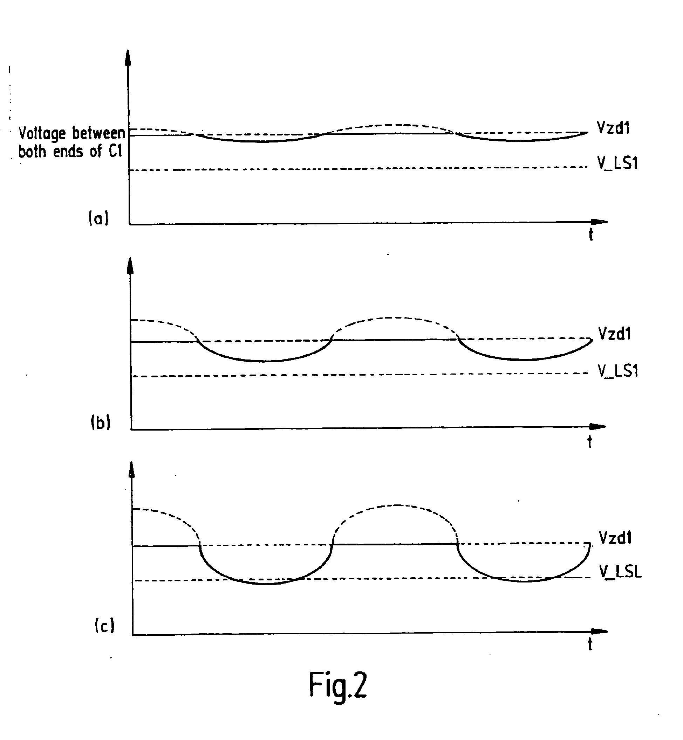

[Fig. 2] Fig. 2 (a) is a drawing showing a voltage between both ends of an electrolytic capacitor at a beginning period of use of the discharge lamp lighting device according to the first embodiment of the present invention, Fig. 2(b) is a drawing showing a voltage between both ends of the electrolytic capacitor at the middle period of use of the discharge lamp lighting device according to the first embodiment of the present invention, and Fig. 2(c) is a drawing showing a voltage between both ends of the electrolytic capacitor at the expiration of life time of the discharge lamp lighting device according to the first embodiment of the present invention.

[Fig. 3] Fig. 3 is a schematic configuration view showing a concrete example of a life time detection circuit in the discharge lamp lighting device according to the first embodiment of the present invention.

[Fig. 4] Fig. 4 is a drawing showing a schematic configuration of a discharge lamp lighting device according to a second embodiment of the present invention.

[Fig. 5] Fig. 5 is a drawing showing a schematic configuration of a discharge lamp lighting device according to a third embodiment of the present invention.

[Fig. 6] Fig. 6 is a plane view showing a state of mounting of a discharge lamp lighting device according to a fourth embodiment of the present invention to a printed circuit board.

[Fig. 7] Fig. 7 is a plane view showing a modified example in the state of mounting of the discharge lamp lighting device according to the fourth embodiment of the present invention to the printed circuit board.

[Fig. 8] Fig. 8 is a perspective view showing a schematic configuration of an illumination fixture according to a fifth embodiment of the present invention.

[Fig. 9] Fig. 9 is a drawing showing a schematic configuration of a conventional discharge lamp lighting device.

[Description of Reference Numerals]

12 Alternating current-direct current conversion circuit
13 Lighting control circuit
131 Frequency control circuit
14 Life time detection circuit
C1 Electrolytic capacitor
FL Discharge lamp
L1 Resonant inductor

[Best Mode for Carrying Out the Invention]

Referring to drawings, a discharge lamp lighting device and an illumination fixture according to embodiments of the present invention will be explained.

(First embodiment)

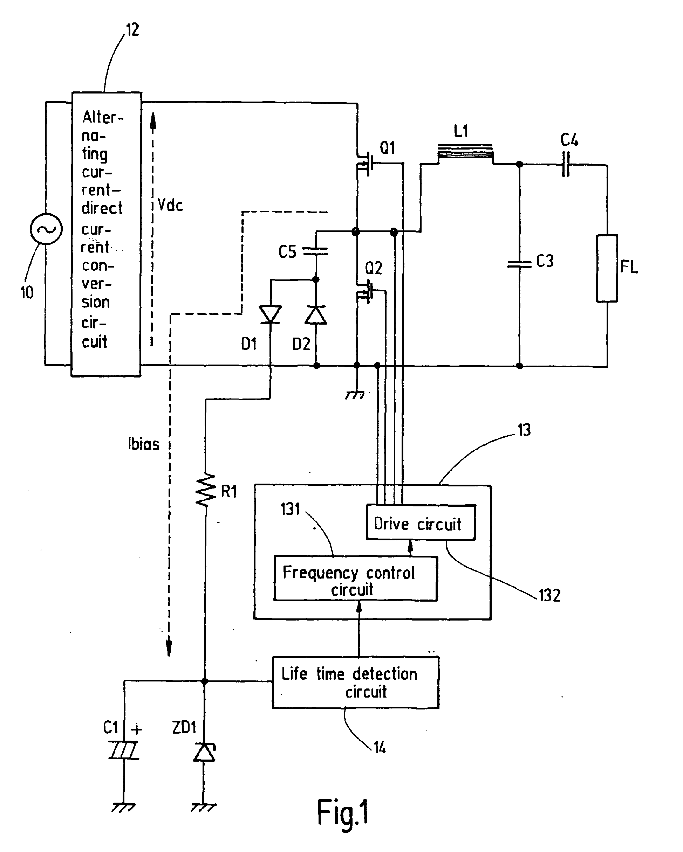

Fig. 1 is a drawing showing a schematic configuration of a discharge lamp lighting device according to a first embodiment of the present invention. The discharge lamp lighting device according to the present embodiment employs a half-bridge type inverter circuit.

In Fig. 1, a series circuit including switching elements Q1 and Q2 is connected to an output terminal (a voltage Vdc) of an alternating current-direct current conversion circuit 11 for converting an alternating current of a commercial power source 10 into a direct current. Then, a series resonant circuit including a resonant inductor L1 and a capacitor C3 is connected between: a connection point of the switching elements Q1 and Q2; and the GND, and further a discharge lamp load FL is connected to both ends of the resonant capacitor C3 via a direct-current blocking capacitor C4.

In addition, a capacitor C5 and a diode D2 are connected in series between: the connection point of the switching elements Q1 and Q2; and the GND. And, a diode D1, a current-limiting resistor R1, and an electrolytic capacitor C1 and a zener diode ZD1 connected in parallel are connected between the connection point and the GND.

A connection point of a (+) side of the electrolytic capacitor C1 and a cathode of the zener diode ZD1 is connected to a lifetime detection circuit 14 for detecting a life time of the discharge lamp lighting device, and an output of the lifetime detection circuit 14 is connected to a frequency control circuit 131 of a lighting control circuit 13.

The operation of the inverter circuit in Fig. 1 is commonly known, and thus the switching elements Q1 and Q2 are alternatively turned on or off by a drive circuit 132 that operates on the basis of a frequency determined by the frequency control circuit 131 of the lighting control circuit 13 and apply an alternating current to the discharge lamp FL after converting the direct current Vdc into a high frequency voltage. Here, since a series resonant circuit including the inductor L1, the capacitor C3, and the capacitor C4 exist in a power supply path to the discharge lamp FL, the energy supplied to the discharge lamp FL can be controlled depending on a relationship between a period of the turning-on and the turning-off of the switching elements Q1 and Q2 (an operation frequency) and a resonant frequency determined by the inductor L1 and the capacitors C3 and C4.

In the discharge lamp lighting device configured as described above, when the switching element Q1 is turned on and the switching element Q2 is turned off, the capacitor C5 is charged at the voltage Vdc, a bias current Ibias flows via the diode D1 and the current-limiting resistor R1, and the electrolytic capacitor C1 is charged.

The bias current at this time is determined by a following expression:

$$Ibias = C5 \times Vdc \times f \quad \cdots \quad (1).$$

Here, the Vdc is controlled to be constant by the alternating current-direct current conversion circuit 12 regardless of an input voltage. In addition, a symbol "f" represents an on-off period of the switching elements Q1 and Q2, and the period is used for determining energy supplied to the discharge lamp FL and is fixed to be approximately constant regardless of the input voltage.

Accordingly, since the expression (1) does not include a term that changes depending on the input voltage, the bias current Ibias becomes constant regardless of the input voltage.

On the other hand, when the switching element Q1 is turned off and the switching element Q2 is turned off, the capacitor C5 is discharged via the diode D2 connected to the switching element Q2 and the GND. At this time, the electric charge charged in the electrolytic capacitor C1 is blocked by the diode D1 and thus does not flow to the capacitor C5.

In the above-mentioned manner, the electrolytic capacitor C1 is charged in every half cycle where the switching element Q1 is turned on.

The zener diode ZD1 has a function for clipping the charging voltage of the electrolytic capacitor C1 at a zener voltage Vzd 1.

The electrolytic capacitor C1 reduces the electrostatic capacity as time of use becomes longer and increases an amplitude of the ripple voltage.

Fig. 2 is a drawing showing changes of a voltage between both ends of the electrolytic capacitor C1 with the time of use. Fig. 2(a) shows a state where the ripple voltage between both ends of the electrolytic capacitor C1 is small and is approximately equal to the zener voltage Vzd1 at the beginning period of use, and Fig. 2(b) shows a state where an amplitude of the ripple voltage slightly increases at the middle period of use. In addition, Fig. 2(c) shows a state where the amplitude of the ripple voltage has been maximized at the expiration of life time of the electrolytic capacitor C1.

As shown in Fig. 2(c), when the amplitude of the ripple voltage becomes lower than a predetermined threshold value V_LSL, the life time detection circuit 14 outputs an instruction to change the operation frequency f to the frequency control circuit 131 of the lighting control circuit 13.

The frequency control circuit 131 changes the operation frequency on the basis of the instruction from the life time detection circuit 14. As described above, since the energy supplied to the discharge lamp FL varies depending on the operation frequency f, the discharge lamp FL can be controlled to be brighter than or to be dimmed less than a normal state by changing the operation frequency, and in this manner, the life time of the discharge lamp lighting device can be informed to a user.

In addition, since the bias current Ibias to the electrolytic capacitor C1 is constant regardless of the input voltage, a heat value of the electrolytic capacitor C1 is also constant regardless of the input voltage. Accordingly, the life time of the electrolytic capacitor C1 is constant regardless of the input voltage. In this manner, the life time of the discharge lamp lighting device can be managed presuming the life time is constant regardless of the input voltage.

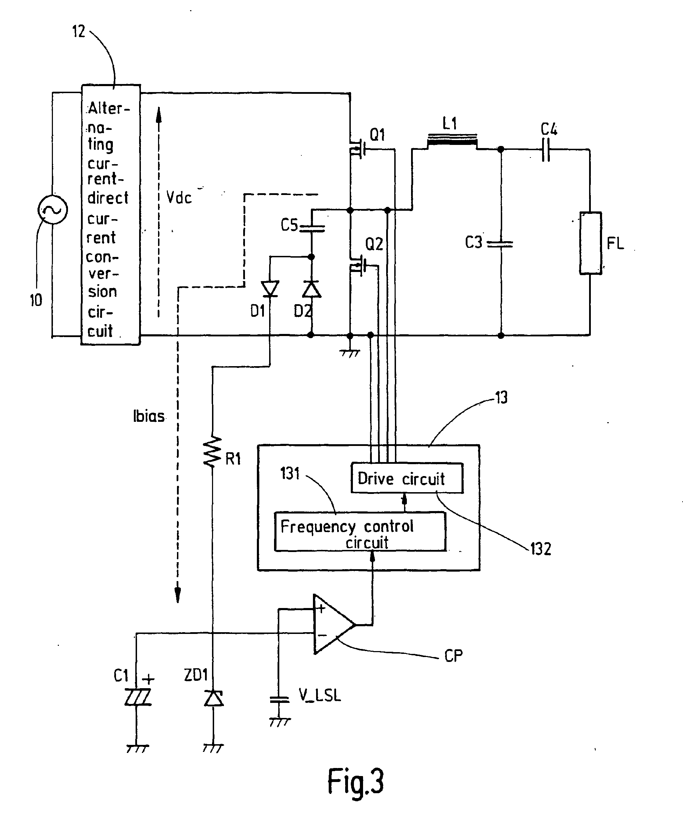

Fig. 3 is a drawing showing a schematic configuration of the lighting control device of a case where a comparator is used as a concrete example of the life time detection circuit 14 in Fig. 1. Meanwhile, explanations of same components as those of Fig. 1 will be simplified or omitted by adding same numerals to the components.

In Fig. 3, a (-) terminal of the comparator CP is connected to a connection point between a (+) side of the electrolytic capacitor C1 and the cathode of the zener diode ZD1, and a preliminarily-determined reference voltage V_LSL is applied to the (+) terminal. And an output terminal of the comparator CP is connected to the frequency control circuit 131 of the lighting control circuit 13.

When the amplitude of the ripple voltage between both ends of the electrolytic capacitor C1 becomes lower than the reference voltage V_LSL, an output of the comparator CP is reversed from an L-level to an H·level and outputs an instruction to change the operation frequency f to the frequency control circuit 131.

As described above, such discharge lamp lighting device according to the first embodiment of the present invention connects the electrolytic capacitor to the connection point of the switching element that is alternatively turned on or off in the inverter circuit, and charges the capacitor by using the supplied bias current. Since increasing with passage of the time of use, the ripple voltage between both ends of the electrolytic capacitor is detected by the life time detection circuit, and outputs the instruction to change a frequency to the lighting control circuit when the voltage exceeds a predetermined threshold value.

The lighting control circuit changes the operation frequency of the discharge lamp on the basis of the instruction, and controls the discharge lamp FL to be brighter than or to be dimmed less than a normal state. In this manner, the life time of the discharge lamp lighting device can be notified to a user.

(Second embodiment)

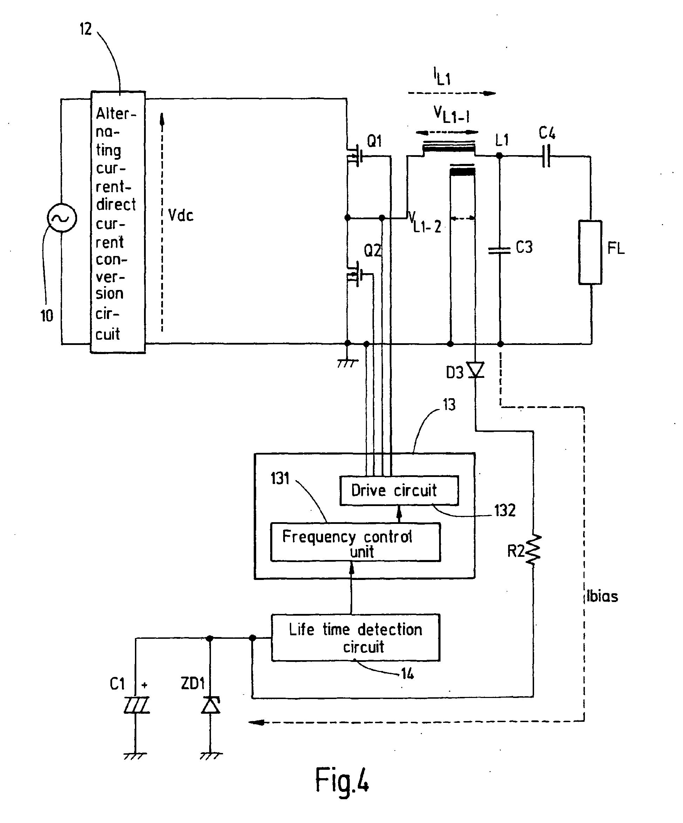

Fig. 4 is a drawing showing a schematic configuration of a discharge lamp lighting device according to a second embodiment of the present invention. The second embodiment is different from the first embodiment in that the bias current is obtained from a secondary winding of the resonant inductor. Meanwhile, explanations of same components as those of Fig. 1 will be simplified or omitted by adding same numerals to the components.

In Fig. 4, one end of the secondary winding magnetically connected to the inductor L1 is connected to the connection point of the (+) side of the electrolytic capacitor C1 and the cathode of the zener diode ZD1 via a diode D3 and a current-limiting resistor R2.

When a resonant current $I_{L1}$ flows to the inductor L1, an alternating-current voltage $V_{L1-1}$ is generated between both ends of the inductor while the discharge lamp FL normally operates. The resonant current $I_{L1}$ is determined on the basis of: the on-off period of the switching elements Q1 and Q2; and impedances of the capacitors C3 and C4 and of the discharge lamp FL, is energy supplied to the discharge lamp FL, and accordingly is determined to be approximately constant regardless of an input voltage from the commercial power source 10. Thus, the alternating-current voltage $V_{L1-1}$ in a normal operation is also approximately constant regardless of the input voltage.

In the secondary winding of the inductor L1, an alternating-current voltage $V_{L1-2}$ is induced when the resonant current $I_{L1}$ flows, and the bias current Ibias flows. The alternating-current voltage $V_{L1-2}$ is determined on the basis of a winding ratio of a primary coil to a secondary coil in the inductor L1.

The half-wave rectification is carried out to the bias current Ibias by the diode D3, and the bias current Ibias charges the electrolytic capacitor C1 via the current-limiting resistor R2.

Subsequently, in the same manner as that of the first embodiment, the ripple voltage appearing between both ends of the electrolytic capacitor C1 is detected by the life time detection circuit 14, and when the amplitude of the ripple voltage becomes lower than the predetermined threshold value V_LSL, the life time detection circuit 14 outputs an instruction to change the operation frequency f to the frequency control circuit 131.

As described above, in such discharge lamp lighting device according to the second embodiment of the present invention, the electrolytic capacitor is connected to the secondary winding of the resonant inductor and is charged with the bias current induced by the resonant current in the secondary winding. Since increasing with passage of the time of use, the ripple voltage between both ends of the electrolytic capacitor is detected by the life time detection circuit, and outputs the instruction to change a frequency to the lighting control circuit when the voltage exceeds a predetermined threshold value.

The lighting control circuit changes the operation frequency of the discharge lamp on the basis of the instruction, and controls the discharge lamp FL to be brighter than or to be dimmed less than a normal state. In this manner, the life time of the discharge lamp lighting device can be notified to a user.

(Third embodiment)

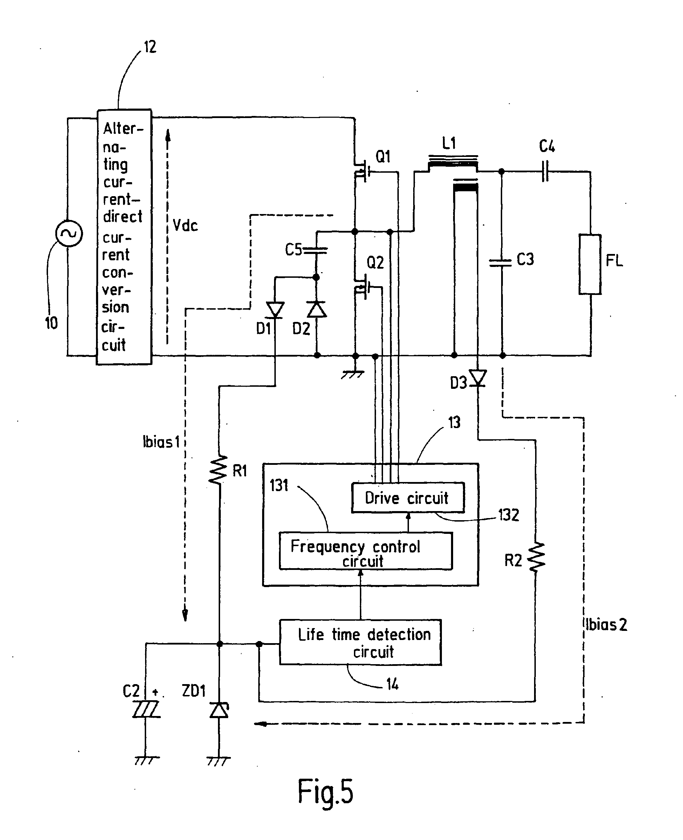

Fig. 5 is a drawing showing a schematic configuration of a discharge lamp lighting device according to a third embodiment of the present invention. The discharge lamp lighting device according to the present embodiment obtains a bias current to be supplied to an electrolytic capacitor in configurations of the first embodiment and the second embodiment. Meanwhile, explanations of same configurations as those of the first and second embodiments will be simplified or omitted by adding same numerals to the configurations.

In Fig. 5, the electrolytic capacitor C1 is charged by: a bias current Ibias 1 generated in accordance with the alternate turning-on and turning-off of the switching elements Q1 and Q2; and a bias current Ibias 2 generated in the secondary winding magnetically connected to the resonant inductor L1 of the inverter circuit.

Then, in the same manner as those of the first and second embodiments, the ripple voltage appearing between both ends of the electrolytic capacitor C1 is detected by the life time detection circuit 14, and when the amplitude of the ripple voltage becomes lower than the predetermined threshold value V_LSL, the life time detection circuit 14 outputs an instruction to change the operation frequency f to the frequency control circuit 131.

As described above, in such discharge lamp lighting device according to the third embodiment of the present invention, the electrolytic capacitor is charged by: the bias current generated in accordance with the turning-on and turning-off of the switching elements; and the bias current generated in the secondary winding magnetically connected to the resonant inductor of the inverter circuit. Since increasing with passage of the time of use, the ripple voltage between both ends of the electrolytic capacitor is detected by the life time detection circuit, and outputs the instruction to change a frequency to the lighting control circuit when the voltage exceeds a predetermined threshold value.

The lighting control circuit changes the operation frequency of the discharge lamp on the basis of the instruction, and controls the discharge lamp FL to be brighter than or to be dimmed less than a normal state. In this manner, the life time of the discharge lamp lighting device can be notified to a user.

(Fourth embodiment)

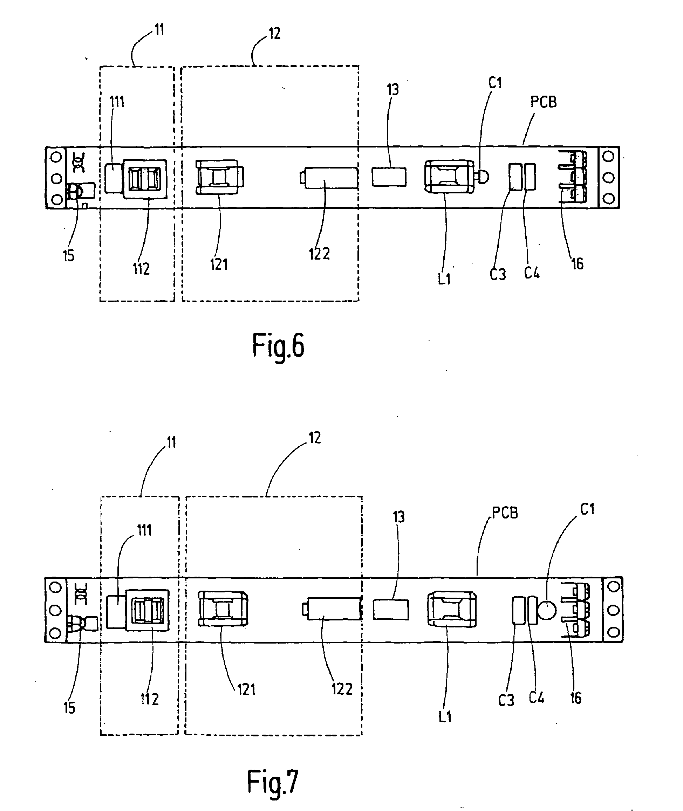

Fig. 6 is a plane view showing a state of mounting of a discharge lamp lighting device according to a fourth embodiment of the present invention to a printed circuit board. In the present embodiment, a schematic configuration of the discharge lamp lighting device is basically the same as those of the first to third embodiments, the explanations will be simplified or omitted by adding same numerals to components.

As shown in Fig. 6, the components are mounted on a printed circuit board PCB; a noise prevention capacitor 111 and an input filter 112 constituting an input filter part 11, a boost transformer 121 and an electrolytic capacitor 122 constituting the alternating current-direct current conversion circuit 12, the lighting control circuit 13, the resonant inductor L1 and the electrolytic capacitor C1 arranged close to the inductor L1, and the capacitors C3 and C4 are arranged, respectively along a right and left sides of the longitudinal direction, and an input connector 15 and an output connector 16 are arranged to the both ends.

As described above, currents flowing to the input filter part 11 and the alternating current-direct current conversion circuit 12 vary depending on an input voltage from the commercial power source 10, and the currents become large when the input voltage is low.

On the other hand, in components arranged following the lighting control circuit 13, a flowing current is determined depending on an operation frequency and the flowing current does not change even when the input voltage varies. Therefore, a surface temperature of the components is approximately constant.

Since the bias current of the electrolytic capacitor C1 is approximately constant even when the input voltage varies and a surface temperature of the adjacent resonant inductor L1 is approximately constant, a self heat value of the electrolytic capacitor C1 to a surrounding temperature can be constant regardless of the input voltage. Accordingly, the life time of the discharge lamp lighting device independent from the input voltage can be designed.

Fig. 7 is a plane view showing the modification example in a state of mounting of the discharge lamp lighting device according to the present embodiment.

It is different Fig. 5 from Fig. 7 in that the electrolytic capacitor C1 is arranged in the vicinity of the capacitor C4 close to the output connector 16.

In a case where the surface temperature of components close to the output connector 16 is influenced by an effect of the heating of components on a side of the input connector 15, the components are hardly influenced by the effect when arranged closest to the output connector 16 as in the present example.

As described above, in such the discharge lamp lighting device according to the fourth embodiment of the present invention, the self heat value of the electrolytic capacitor to the surrounding temperature can be constant regardless of the input voltage by arranging the electrolytic capacitor close to the resonant inductor whose surface temperature is constant regardless of the input voltage in the mounting to the printed circuit board. Accordingly, the life time of the discharge lamp lighting device independent from the input voltage can be designed.

In addition, the electrolytic capacitor can be hardly influenced by the effect when arranged closest to the output connector.

(Fifth embodiment)

Fig. 8 is a perspective view showing a schematic configuration of an illumination fixture according to a fifth embodiment of the present invention. The illumination fixture of the present embodiment mounts any one of the discharge lamp lighting devices explained in the first to fourth embodiments.

In Fig. 8, the illumination fixture is configured by including a fixture body 20, a reflection plate 21, sockets 22 and 23, a spring 24, and a lamp-pin connection hole 25. And, any one of the discharge lamp lighting devices explained in the first to fourth embodiments is internally incorporated in the fixture body 20.

The discharge lamp attached to the sockets 22 and 23 is a straight tube type used for facilities and shops. In addition, the lamp may be a circular type mainly used for a house or may be a compact type mainly used for a fixture of a downlight.

As described above, in such illumination fixture according to the fifth embodiment of the present invention, the same effects as those of the discharge lamp lighting devices of the first to fourth embodiments can be obtained.

Industrial applicability

The discharge lamp lighting device and the illumination fixture of the present invention are able to manage the life time regardless of the input voltage and have an effect enabling notification of the expiration of the life time, and are useful for an illumination fixture and an illumination system in general facilities, in indoor or outdoor place, and so on.

**Claims**

1. A discharge lamp lighting device comprising: an alternating current-direct current conversion circuit (12) for converting an alternating current of an arbitrary voltage into a direct current of a predetermined voltage; an inverter circuit (Q1, Q2) for converting the direct current of the predetermined voltage into a high-frequency voltage; a resonant circuit including a capacitor (C3) and an inductor (L1) for lighting a discharge lamp; and a lighting control circuit (13) for controlling the operations, further comprising:

   an electrolytic capacitor (C1) charged by a constant high-frequency current; and
   a life time detection circuit (14) for detecting a life time of the electrolytic capacitor,
   **characterized in that**
   the life time detection circuit determines that the life of the electrolytic capacitor expired when a ripple voltage of the electrolytic capacitor exceeds a predetermined threshold value, and issues an instruction to the lighting control circuit; and
   the lighting control circuit is configured so as to change an operating frequency of the inverter circuit on the basis of the instruction.

2. The discharge lamp lighting device according to claim 1, wherein the electrolytic capacitor is configured so as to be charged by the high-frequency current obtained from the inverter circuit.

3. The discharge lamp lighting device according to claim 1, wherein:

   the inductor includes a magnetically- connected secondary winding; and
   the electrolytic capacitor is configured so as to be charged by the high-frequency current induced by the secondary winding.

4. The discharge lamp lighting device according to any one of claims 1 to 3, wherein:

   the electrolytic capacitor is mounted close to a component, a surface temperature of which is constant in an operation.

5. A illumination fixture comprising the discharge lamp lighting device according to any one of claims 1 to 4.

**Patentansprüche**

1. Beleuchtungsvorrichtung für eine Entladungslampe, die aufweist: eine Wechselstrom-Gleichstrom-Wandlerschaltung (12) zur Umwandlung eines Wechselstroms mit einer willkürlichen Spannung in einen Gleichstrom mit einer vorbestimmten Spannung; eine Inverterschaltung (Q1, Q2) zur Umsetzung des Gleichstroms mit der vorbestimmten Spannung in eine hochfrequente Spannung; eine Resonanzschaltung, die einen Kondensator (C3) und eine Spule (L1) zur Beleuchtung einer Entladungslampe enthält; und eine Beleuchtungssteuerschaltung (13) zur Steuerung der Betriebszustände, die ferner aufweist:

   einen elektrolytischen Kondensator (C1), der durch einen konstanten hochfrequenten Strom geladen wird; und
   eine Lebensdauererfassungsschaltung (14) zur Erfassung einer Lebensdauer des elektrolytischen Kondensators,
   **dadurch gekennzeichnet, dass**
   die Lebensdauererfassungsschaltung feststellt, dass die Lebensdauer des elektrolytischen Kondensators abgelaufen ist, wenn eine Rippelspannung des elektrolytischen Kondensators einen vorbestimmten Schwellenwert überschreitet, und einen Befehl an die Beleuchtungssteuerschaltung ausgibt; und
   wobei die Beleuchtungssteuerschaltung konfiguriert ist, um eine Betriebsfrequenz der Inverterschaltung auf der Basis des Befehls zu verändern.

2. Beleuchtungsvorrichtung für eine Entladungslampe nach Anspruch 1, wobei
der elektrolytische Kondensator konfiguriert ist, um durch den von der Inverterschaltung erhaltenen hochfrequenten Strom geladen zu werden.

3. Beleuchtungsvorrichtung für eine Entladungslampe nach Anspruch 1, wobei:

die Spule eine magnetisch gekoppelte Sekundärwicklung enthält; und

der elektrische Kondensator konfiguriert ist, um durch den durch die Sekundärwicklung induzierten hochfrequenten Strom geladen zu werden.

4. Beleuchtungsvorrichtung für eine Entladungslampe nach einem beliebigen der Ansprüche 1 bis 3, wobei:

der elektrolytische Kondensator in der Nähe einer Komponente montiert ist, deren Oberflächentemperatur im Betrieb konstant ist.

5. Beleuchtungsbefestigung, die die Entladungslampenbeleuchtungsvorrichtung nach einem beliebigen der Ansprüche 1 bis 4 aufweist.

**Revendications**

1. Dispositif d'allumage de lampe à décharge comprenant : un circuit de conversion courant alternatif-courant continu (12) pour convertir un courant alternatif de tension arbitraire en un courant continu de tension prédéterminée ; un circuit onduleur (Q1, Q2) pour convertir le courant continu de tension prédéterminée en une tension à haute fréquence ; un circuit résonnant comprenant un condensateur (C3) et une inductance (L1) pour allumer une lampe à décharge ; et un circuit de commande d'allumage (13) pour commander les opérations, comprenant en outre :

un condensateur électrolytique (C1) chargé par un courant constant à haute fréquence ; et
un circuit de détection de durée de vie (14) pour détecter une durée de vie du condensateur électrolytique,
**caractérisé en ce que** :
le circuit de détection de durée de vie détermine que la vie du condensateur électrolytique a expiré quand une tension d'ondulation du condensateur électrolytique dépasse une valeur de seuil prédéterminée, et délivre une instruction au circuit de commande d'allumage ; et
le circuit de commande d'allumage est configuré pour changer une fréquence de fonctionnement du circuit onduleur en se basant sur l'instruction.

2. Dispositif d'allumage de lampe à décharge selon la revendication 1, dans lequel le condensateur électrolytique est configuré pour être chargé par le courant à haute fréquence fourni par le circuit onduleur.

3. Dispositif d'allumage de lampe à décharge selon la revendication 1, dans lequel :

l'inductance comprend un enroulement secondaire connecté magnétiquement ; et
le condensateur électrolytique est configuré pour être chargé par le courant à haute fréquence induit par l'enroulement secondaire.

4. Dispositif d'allumage de lampe à décharge selon l'une quelconque des revendications 1 à 3, dans lequel le condensateur électrolytique est monté près d'un composant dont une température de surface est constante pendant le fonctionnement.

5. Appareil d'éclairage comprenant le dispositif d'allumage de lampe à décharge selon l'une quelconque des revendications 1 à 4.

Fig.1

Fig.2

Fig.3

Fig.4

Fig.5

Fig.6

Fig.7

**Fig.8**

**Fig.9**

Light-
ning
control
circuit

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H07222436 B
- JP 2006129564 A
- EP 1814214 A1